# EUROPÄISCHE PATENTANMELDUNG

(11) **EP 0 650 068 A2**
(43) Veröffentlichungstag der Anmeldung: **26.04.1995**
(21) Anmeldenummer: 94114988.2
(22) Anmeldetag: 23.09.1994
(51) Int. Cl.: G01R 31/11

(54) **Verfahren und Vorrichtung zur Ortung von Kabelfehlern**

(30) Priorität: 21.10.1993 DE 4335924
(71) Anmelder: HAGENUK GMBH, D-24118 Kiel (DE)
(72) Erfinder: Lefeldt, Ekkehard, D-24619 Bornhöved (DE)
(74) Vertreter: Hansmann, Dierk, Dipl.-Ing.

(57) **Zusammenfassung**

Das Verfahren dient zur Ortung von Kabelfehlern, insbesondere zur Ortung nichtfestbrennbarer Kabelfehler im Bereich von verzweigten Kabeln. Es wird die Impulsreflexionsmethode angewendet und ein Kondensator geladen, der anschließend über eine Funkenstrecke durch Funkenüberschlag an einer Fehlerstelle des Kabels entladen wird. Parallel zu einem Hauptkondensator in einem Stoßwellengenerator wird ein zweiter Impulskondensator über einen Kurzschlußschalter auf das Kabel entladen. Die entstehende Reflexionswelle wird über eine Auskoppelung einem ersten Kanal des Digitalspeichers zugeführt. Nach Öffnen des Kurzschlußschalters werden der Hauptkondensator im Stoßwellengenerator und der zweite Impulskondensator erneut aufgeladen und anschließend wiederum durch Schließen des Hauptschalters auf das fehlerhafte Kabel entladen. Die Entladung des Impulskondensators erfolgt über eine plasmagetriggerte Funkenstrecke. Die Funkenstrecke wird aus der Ladung des Stoßwellengenerators getriggert. Durch eine Zeitverzögerung bei der Plasmabildung erreicht ein Entladeimpuls des Impulskondensators die Fehlerstelle im Kabel nach bereits erfolgter Zündung. Die dabei entstehende zündverzögerungsfreie Reflexionswelle wird über die Auskoppelung einem zweiten Kanal des Digitalspeichers zugeführt. Durch eine Auswertung auftretender Abweichungen beider Aufzeichnungen wird der Fehlerort ermittelt.

## Beschreibung

Die Erfindung betrifft eine Verfahren zur Ortung von Kabelfehlern, insbesondere zur Ortung nichtfestbrennbarer Kabelfehler im Bereich von verzweigten Kabeln nach der Impulsreflexionsmethode, bei dem ein Kondensator geladen und über eine Funkenstrecke durch Funkenüberschlag an einer Fehlerstelle des Kabels entladen wird und bei dem im Bereich eines Digitalspeichers zur Fehlerstellendetektion eine Überlagerung von zwei Messungen durchgeführt wird.

Die Erfindung betrifft darüber hinaus eine Vorrichtung zur Ortung von Kabelfehlern, insbesondere zur Ortung nicht festbrennbarer Kabelfehler im Bereich von verzweigten Kabeln nach dem Impulsreflexionsmethode, die einen ladbaren Kondensator und eine Funkenstrecke aufweist, die den Kondensator an das Kabel anschließt und die einen Digitalspeicher zur Erfassung und Speicherung von zwei Meßverläufen aufweist.

Mit Hilfe eines derartigen Verfahrens und einer derartigen Vorrichtung ist es insbesondere möglich, eine Vorortung von hoch- und mittelohmigen nichtfestbrennbaren Kabelfehlern durchzuführen. Durch die Entladung des Kondensators über die Funkenstrecke wird eine Reflexionswelle im Bereich der Fehlerstelle des Kabels erzeugt, aus der die Entfernung zur Fehlerstelle ermittelt werden kann.

Es ist bekannt, Kabelfehler durch Hochspannungsimpulse aus Kondensatorentladungen durch Darstellung der Reflexionswelle zu orten. Die Brauchbarkeit dieser Methode wird durch die Zündverzögerung an der Fehlerstelle eingeschränkt. D.h., die der Fehlerentfernung proportionale Laufzeit wird um die Zündverzögerung unbefriedigend bestimmbar verlängert.

Aus der DE 41 00 305 A1 ist eine Schaltungsanordnung zur Vorortung hochohmiger und intermittierender Kabelfehler unter Verwendung der Impuls-Echo-Methode bekannt. Es wird in Verbindung mit einem Ladekondensator von einem Stoßwellengenerator eine Stoßwelle an einer Luftfunkenstrecke zur Zündung des Kabelfehles ausgelöst.

Es sind ebenfalls Methoden zur Impulsvorortung mit Hochspannungsimpulsen bekannt geworden, bei denen durch geeignete Vorionisation der Fehlerstelle die Zündverzögerung nicht wirksam wird. Diese Methoden sind in der deutschen Offenlegungsschrift DE 39 19 497 ausführlich beschrieben.

Der wesentliche Gegenstand der Offenlegungsschrift DE 39 19 497 betrifft ein Verfahren, beim dem die Ladung eines Kondensators auf das fehlerhaft Kabel geschaltet und nach dem Überschlag an der Fehlerstelle ein Lichtbogen erzeugt wird.

Wenn durch den Lichtbogenstrom die Kondensatorspannung auf einen bestimmten Wert abgesunken ist, wird durch Kurzschluß des strombegrenzenden Elementes seine Restladung impulsartig auf das fehlerhafte Kabel entladen und die auf diese Weise erzeugte Reflexionswelle einem ersten Kanal eines Digitalspeichers zur Aufzeichnung zugeführt.

Vorher oder hinterher wird eine Reflexionswelle von einer Impulsspannung, die kleiner als die Zündspannung des Fehlers ist, also eine Reflexionswelle ohne Fehlerzündung, einem zweiten Kanal des Digitalspeichers zur Aufzeichnung zugeführt. Durch Übereinanderschreiben der Aufzeichnungen beider Kanäle wird der Fehlerort bestimmt. Dieses Verfahren eignet sich vornehmlich für hochohmige und intermittierende Fehler.

Mittelohmige Fehler dagegen, wie sie z.B. auftreten, wenn die Fehlerstelle im Wasser liegt oder unmittelbaren Kontakt zum feuchten Erdreich hat, bilden mit dem strombegrenzenden Element einen Spannungsteiler, der die Spannung am Fehler oft soweit reduziert, daß dieser nicht mehr zu einer Zündung führt. Die Spannung am Kondensator sinkt deshalb durch den Strom über den Ableitwiderstand auf die Impulsauslösespannung, ohne daß eine Fehlerzündung stattgefunden hat. Die Aufzeichnungen des Digitalspeichers enthalten keine Informationen über den Fehlerort.

Ferner wird gemäß dem Stand der Technik eine aufwendige Einrichtung zum schnellen Kurzschließen des strombegrenzenden Elementes benötigt. Es muß ausreichend Hilfsenergie für den Schaltvorgang bereit gestellt werden.

Als Impulskondensator dient der Kondensator eines Stoßwellengenerators. Diese Kondensatoren sind für hohe Energiedichte ausgelegt, weisen aber nicht unbedingt eine geringe Eigeninduktivität auf. Außerdem werden sie als einzelne Teilkondensatoren für mehrere Spannungen umschaltbar ausgeführt. Die Leitungsverbindungen zum Umschalter erhöhen die wirksame Induktivität.

Im Interesse einer hohen Ortungsgenauigkeit sollte die Flankensteilheit des Impulses aber möglichst groß und damit die Induktivität des Kreises möglichst klein sein.

Der Kondensator gemäß der DE-OS 39 19 497 dient sowohl zur Lichtbogen- als auch zur Impulserzeugung. Dadurch steht immer nur ein Teil der ursprünglichen Ladespannung als Impulsspannung zur Verfügung. Bei schwierigen Zündbedingungen kann das von Nachteil sein.

Aufgabe der vorliegenden Erfindung ist es daher, ein Verfahren der einleitend genannten Art derart zu verbessern, daß die Ortungsqualität erhöht wird.

Diese Aufgabe wird erfindungsgemäß dadurch gelöst, daß parallel zu einem Hauptkondensator in einem Stoßwellengenerator ein zweiter Impulskondensator aufgeladen wird, der Hauptkondensator im Stoßwellengenerator über eine Spule und der Impulskondensator über einen geschlossenen Kurzschlußschalter durch Schließen eines Hauptschalters auf das fehlerhafte Kabel entladen werden und eine dadurch entstehende Reflexionswelle über ein Auskoppelung einem ersten Kanal des Digitalspeichers zur Aufzeichnung zugeführt wird und daß nach Öffnen des Kurzschlußschalters der Hauptkondensator im Stoßwellengenerator und der zweite Impulskondensator erneut aufgeladen und anschließend wiederum durch Schließen des Kurzschlußschalters auf das fehlerhafte Kabel entladen werden, wobei die Entladung des Impulskondensators über eine plasmagetriggerte Funkenstrecke erfolgt, die über eine Zündspule aus der Ladung des Stoßwellengenerators getriggert wird, wobei durch eine Zeitverzögerung bei der Plasmabildung und Auslenkung ein Entladeimpuls des Impulskondensators die Fehlerstelle im Kabel nach bereits erfolgter Zündung erreicht und die dabei entstehende zündverzögerungsfreie Reflexionswelle über die Auskoppelung einem zweiten Kanal des Digitalspeichers zur Aufzeichnung zugeführt wird und daß durch eine Auswertung auftretender Abweichungen beider Aufzeichnungen durch Umrechnung der jeweiligen Impulsreflexionszeiten in Entfernungswerte der Fehlerort ermittelt wird.

Weitere Aufgabe der Erfindung ist es, eine Vorrichtung der einleitend genannten Art derart anzugeben, daß die Vorortung hoch- und mittelohmiger Kabelfehler erleichtert wird.

Diese Aufgabe wird erfindungsgemäß dadurch gelöst, daß ein Stoßwellengenerator mit einem Hauptkondensator versehen ist, dessen einer Anschluß direkt und dessen anderer Anschluß über eine Spule und einen Hauptschalter mit dem Kabel verbunden ist, daß ein zweiter Impulskondensator über einen Kontakt gemeinsam mit dem Hauptkondensator direkt an das Kabel angeschlossen ist und über einen anderen Kontakt über einen Kurzschlußschalter und den Hauptschalter an das Kabel anschließbar ist, daß eine Funkenstrecke mit einer Triggerelektrode und einer Hauptelektrode versehen ist, wobei die Triggerelektrode über eine Zündspule, die magnetisch mit der Spule gekoppelt ist, an eine Verbindungsstelle des Hauptkondensators, der Spule und eines Ladewiderstandes des zweiten Impulskondensators angeschlossen ist und der Kurzschlußschalter als Kurzschlußschalter für die Hauptelektroden ausgebildet ist und daß über eine Auskopplung ein Digitalspeicher an eine Zuleitung des Impulskondensators angeschlossen ist, die den Impulskondensator mit dem Kabel verbindet.

Es werden somit sich unterscheidende Meßverläufe generiert, die durch eine Überlagerung und eine Auswertung der Signaldifferenzen eine genaue Ortung des Kabelfehlers erlaubt. Hierbei wird ausgenutzt, daß unterschiedliche Impulsreflexionslaufzeiten in Abhängigkeit vom jeweiligen Durchschlagszustand des Kabels vorliegen.

Eine Modifizierung bei einem niedrigen Ableitwiderstand des Kabels und einer hierdurch hervorgerufenen Spannungsteilung zwischen dem induktiven Widerstand der Spule und dem Ableitwiderstand, die eine Verhinderung einer Fehlerzündung zur Folge haben kann, kann dadurch erfolgen, daß bei geschlossenem Kurzschlußschalter eine Reflexionswelle über die Auskoppelung einem ersten Kanal des Digitalspeichers zur Aufzeichnung zugeführt wird und anschließend die Ladespannung des Stoßwellengenerators und die Ladespannung des Impulsskondensators auf die maximal mögliche Spannung gesteigert wird und die Kondensatoren bei geschlossenem Kurzschlußschalter durch Schließen des Hauptschalters auf das fehlerhafte Kabel entladen werden und daß die Reflexionswelle über die Koppeleinrichtung einem zweiten Kanal des Digitalspeichers zur Aufzeichnung zugeführt wird und anschließend die Aufzeichnungen beider Kanäle derart übereinandergeschrieben werden, daß ein auftretender Abweichungspunkt beider Aufzeichnungen einen Ort weiter entfernt als der tatsächliche Fehlerort detektiert, und daß eine weitere Nachortung in Richtung auf einen Kabelanfang durchgeführt wird.

Eine Verbesserung der Flankensteilheit zur Gewährleistung einer genauen Ortung kann dadurch erfolgen, daß der Impulskondensator eine geringe Eigeninduktivität aufweist. Der Impulskondensator kann hierzu koaxial oder zumindest stirnkontaktiert ausgeführt sein.

Bei einer ausreichend hohen Spannung des Stoßwellengenerators zur Gewährleistung einer sicheren Zündung der Funkenstrecke ist es auch möglich, daß die Zündspule und die Spule als ein einheitliches Bauelement ausgebildet sind.

Eine zweckmäßige elektrische Dimensionierung erfolgt dadurch, daß der Ladewiderstand eine Dimensionierung derart aufweist, daß bei einem Ladevorgang des Impulskondensators die Spannung am Impulskondensator der Spannung am Hauptkondensator folgt und daß eine ausreichende elektrische Entkopplung des Impulskondensators und des Hauptkondensators beim schnellen Entladevorgang realisiert ist.

In der Zeichnung sind Ausführungsbeispiele der Erfindung schematisch dargestellt. Es zeigen:

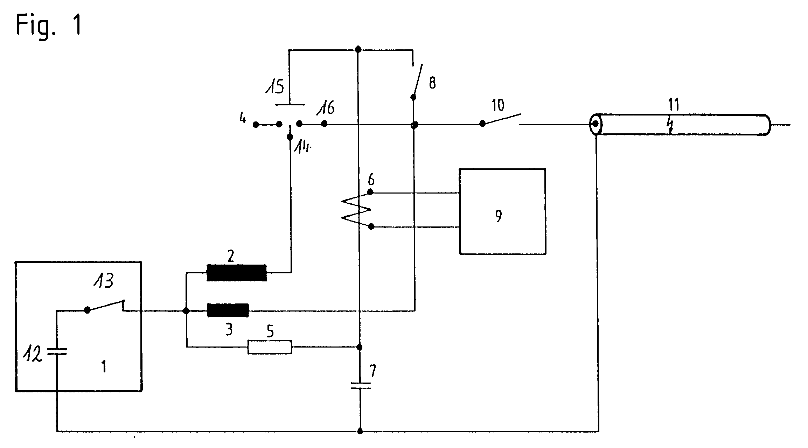

- Fig. 1: zeigt das Prinzipschaltbild mit den wesentlichen elektrischen Elementen,

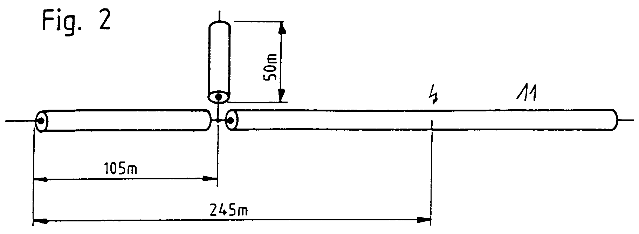

- Fig. 2: zeigt als Beispiel eine Kabelanlage mit einem Abzweig von 50 m Länge in einer Entfernung von 105 m und einer Fehlerentfernung von 245 m mit der die Reflexionswellen von Fig. 3 aufgezeichnet wurden,
- Fig. 3: eine Zusammenstellung unterschiedlicher Reflexionswellen in Abhängigkeit von jeweils vorgenommenen Schaltungseinstellungen.

Zusammen mit einem Hauptkondensator (12) eines Stoßwellengenerators (1) wird ein Impulskondensator (7) über einen Ladewiderstand (5) geladen. Der Ladewiderstand (5) ist so bemessen, daß die Spannung des Impulskondensators (7) der des Hauptkondensators (12) im Stoßwellengenerator (1) beim langsamen Aufladevorgang unmittelbar folgt, beim schnellen Entladen aber kaum nennenswert umgeladen wird.

Ein Kurzschlußschalter (8), der eine plasmagetriggerter Funkenstrecken (4) kurzschließt, bleibt zunächst geschlossen. Beim Betätigen eines Hauptschalters (10) werden der Hauptkondensator (12) im Stoßwellengenerator (1) und der Impulskondensator (7), letzterer mit steiler Flanke, auf ein fehlerhaftes Kabel (11) entladen.

Über eine Auskopplung (6) wird die Reflexionswelle einem ersten Kanal eines Digitalspeichers (9) zur Aufzeichnung zugeführt. Dabei wird die Spannung des Stoßwellengenerators (1), und damit die Spannung des Impulskondensators (7), so eingestellt, daß gerade noch sicher ein Überschlag an der Fehlerstelle entsteht. Aufgezeichnet wird so eine Reflexionswelle mit relativ großer Zündvergrößerung.

Betätigt man den Hauptschalter (10) bei geöffnetem Kurzschlußschalter (8), so wird nach Zünden der Fehlerstelle im Kabel (11) der Hauptkondensator (12) im Stoßwellengenerator (1) über eine Spule (3) in Form einer gedämpften Schwingung entladen. Die Spitzenspannung an der Spule (3) entspricht etwa der Ladespannung des Hauptkondensators (12) im Stoßwellengenerator (1). Die Spule (3) ist mit einer Zündspule (2) eng gekoppelt. Die Spannung der Spule (3) wird so für die Zündung einer Triggerelektrode (14) der plasmagetriggerten Funkenstrecke (4) hochtransformiert. Die Triggerelektrode (14) zündet. Es kommt zu einer Plasmabildung, weil sich der Hauptkondensator (12) im Stoßwellengenerator (1) parallel zu seiner Entladung auf die Fehlerstelle im Kabel (11) jetzt auch über die Spule (2) und die Triggerelektrode (14) in der Funkenstrecke (4) entlädt. Das Plasma wird magnetisch in Richtung auf die Hauptelektrode (15,16) der Funkenstrecke (4) bewegt. Diese zündet und der Impulskondensator (7) entlädt sich auf das fehlerhaft Kabel (11).

Plasmabildung und Bewegung verlaufen relativ langsam, so daß die Hauptelektroden (15,16) der Funkenstrecke (4) erst etwa 1 msec. nach dem Zünden der Fehlerstelle durchschlagen, d.h., die Impulsentladung des Impulskondensators (7) findet die Fehlerstelle gezündet vor. Die Wanderwelle ist abgeklungen.

Die Reflexionswelle, die jetzt von der Auskopplung (6) einem zweiten Kanal des Digitalspeichers (9) zur Aufzeichnung zugeführt wird, ist eine Reflexionswelle ohne Zündverzögerung.

Durch das Übereinanderschreiben beider ermittelter Speicherbilder wird der entsprechende Fehlerpunkt durch das Aufspreizen der aufgenommenen Kurven kenntlich gemacht und die Fehlerentfernung ist genau bestimmbar.

Der Impulskondensator (7) muß so bemessen werden, daß die Impulsbreite auch für größere Kabeldämpfungen und Fehlerentfernungen ausreicht. Das ist bei 1 bis 2 - Mikrofarad der Fall.

Eine hohe Meßgenauigkeit fordert eine hohe Flankensteilheit. Der Impulskondensator (7) muß deshalb eine geringe Eigeninduktivität aufweist, d.h. koaxial oder mindestens stirnkontaktiert ausgeführt werden.

Unterbleibt durch die Spannungsteilung zwischen dem induktiven Widerstand der Spule (3) und dem Ableitwiderstand des fehlerhaften Kabels (11) die Fehlerzündung, so unterbleibt auch durch den erheblich geringeren Spannungsabfall an der Spule (2) die Zündung der Funkenstrecke (4). Der Impulskondensator (7) wird nicht entladen und es entsteht keine Reflexionswelle.

Für diesen Fall erreicht man eine zwar ungenauere aber doch brauchbare Fehlerortbestimmungen durch Steigerung der Spannung des Hauptkondensators (12) Stoßwellengenerator (1) und der Spannung vom Impulskondensator (7) auf die maximal mögliche, beziehungsweise auf die für die betreffende Kabelanlage maximal zulässige Spannung.

Wird jetzt der Hauptschalter (10) bei geschlossenem Kurzschlußschalter (8) betätigt, kann im zweiten Kanal des Digitalspeichers (9) eine Reflexionswelle mit geringer Zündverzögerung aufgezeichnet werden. Schreibt man diese Aufzeichnung, eventuell unter Reduzierung der Verstärkung, über die im ersten Kanal des Digitalspeichers (9) aufgezeichnete Reflexionswelle mit großer Zündverzögerung, wird der Fehlerort in einer größeren Entfernung dargestellt, als es tatsächlich der Fall ist. Der Meßfehler ist aber durch die beschriebene Vorgehensweise minimiert worden. Die Nachortung wird von dem so ermittelten Fehlerort in Richtung auf den Kabelanfang vorgenommen.

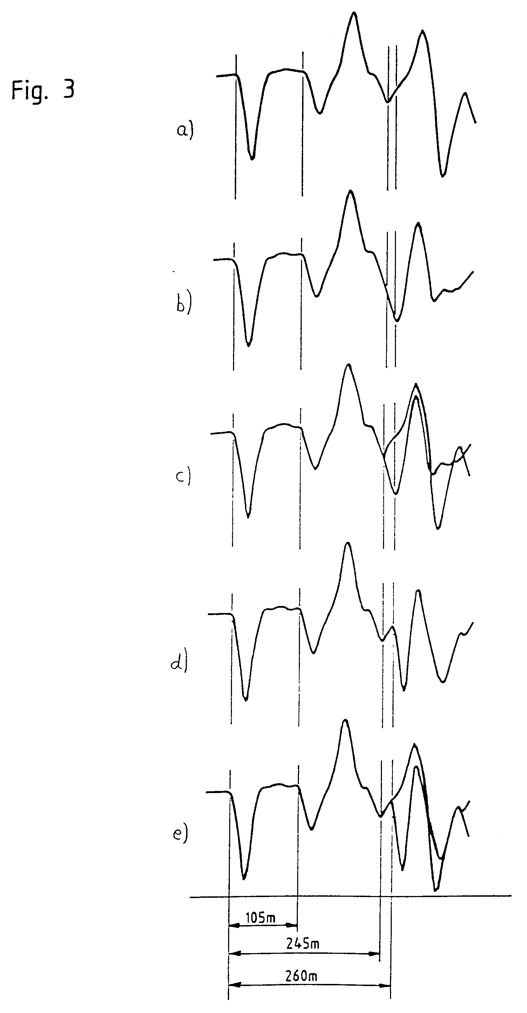

Die Fig. 3 zeigt unter a) die Aufzeichnung einer Relfexionswelle mit geschlossenem Kurzschlußschalter (8) und relativ großer Zündverzögerung. Deutlich erkennbar ist hierbei die Reflexion der Abzweigung nach 105 m. Die eigentliche Fehlerreflexion liegt durch die große Zündverzögerung nicht im Darstellungsbereich.

Im Verlauf b) wird in Fig. 3 die Aufzeichnung einer Reflexionswelle ohne Zündverzögerung wiedergegeben. Es handelt sich hierbei also um eine Impulsentladung des Impulskondensators (7) über die plasmagetriggerte Funkenstrecke (4) bei geöffneten Kurzschlußschalter (8). Die Abzweigreflexionen lassen auch hier keine eindeutige Fehlerortbestimmung zu.

Fig. 3 zeigt unter c) eine Überlagerung der Darstellungen nach a) und b). Die Fehlerstelle erscheint deutlich als Aufspreizung in einer Entfernung von etwa 245 m von der Einspeisungsstelle.

In der Darstellung d) ist in Fig. 3 die Aufzeichnung einer zündverzögerten Reflexionswelle dargestellt, bei der die Stoßwellenspannung auf die für die Kabelanlage maximal zulässige Stoßwellenspannung gesteigert wurde. Durch eine Überlagerung der Darstellungen a) und d) entsteht die Darstellung unter e). Die Fehlerstelle ist jetzt in einer Entfernung von 260 m zu erkennen. Es wurde somit um 15 m zu weit gemessen.

## Patentansprüche

1. Verfahren zur Ortung von Kabelfehlern, insbesondere zur Ortung nichtfestbrennbarer Kabelfehler im Bereich von verzweigten Kabeln nach der Impulsreflexionsmethode, bei dem ein Kondensator geladen und über eine Funkenstrecke durch Funkenüberschlag an einem Fehlerort des Kabels entladen wird und bei dem im Bereich eines Digitalspeichers zur Fehlerstellendetektion eine Überlagerung von zwei Messungen durchgeführt wird, dadurch gekennzeichnet, daß parallel zu einem Hauptkondensator (12) in einem Stoßwellengenerator (1) ein zweiter Impulskondensator (7) aufgeladen wird und der Hauptkondensator (12) im Stoßwellengenerator (1) über eine Spule (3) und der Impulskondensator (7) über einen geschlossenen Kurzschlußschalter (8) durch Schließen eines Hauptschalters (10) auf das fehlerhafte Kabel (11) entladen werden und die dadurch entstehende Reflexionswelle über eine Auskoppelung (6) einem ersten Kanal des Digitalspeichers (9) zur Aufzeichnung zugeführt wird und daß nach Öffnen des Kurzschlußschalters (8) der Hauptkondensator (12) im Stoßwellengenerator (1) und der Impulskondensator (7) erneut aufgeladen und anschließend wiederum durch Schließen des Hauptschalters (10) auf das fehlerhafte Kabel (11) entladen werden, wobei die Entladung des Impulskondensators (7) über eine plasmagetriggerte Funkenstrecke (4) erfolgt, die über eine Spule (2) aus der Ladung des Stoßwellengenerators (1) getriggert wird, wobei durch eine Zeitverzögerung bei der Plasmabildung und Auslenkung ein Entladeimpuls des Impulskondensators (7) die Fehlerstelle im Kabel (11) nach bereits erfolgter Zündung erreicht und die dabei entstehende zündverzögerungsfreie Reflexionswelle über die Auskoppelung (6) einem zweiten Kanal des Digitalspeichers (9) zur Aufzeichnung zugeführt wird und daß durch eine Auswertung auftretender Abweichungen beider Aufzeichnungen durch Umrechnung der jeweiligen Impulsreflexionszeiten in Entfernungswerte der Fehlerort ermittelt wird.

2. Verfahren nach Anspruch 1, dadurch gekennzeichnet, daß bei geschlossenem Kurzschlußschalter (8) eine Reflexionswelle über die Auskoppelung (6) einem ersten Kanal des Digitalspeichers (9) zur Aufzeichnung zugeführt wird und anschließend die Ladespannung des Stoßwellengenerators (1) und die Ladespannung des Impulskondensators (7) auf die maximal mögliche Spannung gesteigert wird und die Kondensatoren (7,12) bei geschlossenem Kurzschlußschalter (8) durch Schließen des Hauptschalters (10) auf das fehlerhafte Kabel (11) entladen werden und daß die Reflexionswelle über die Auskoppelung (6) einem zweiten Kanal des Digitalspeichers (9) zur Aufzeichnung zugeführt wird und anschließend die Aufzeichnungen beider Kanäle derart übereinandergeschrieben werden, daß ein auftretender Abweichungspunkt beider Aufzeichnungen einen Ort weiter entfernt als der tatsächliche Fehlerort detektiert, und daß eine weitere Nachortung in Richtung auf einen Kabelanfang durchgeführt wird.

3. Vorrichtung zur Ortung von Kabelfehlern, insbesondere zur Ortung nichtfestbrennbarer Kabelfehler im Bereich von verzweigten Kabeln nach der Impulsreflexionsmethode, die einen ladbaren Kondensator und eine Funkenstrecke aufweist, die den Kondensator an das Kabel anschließt und die einen Digitalspeicher zur Erfassung und Speicherung von zwei Meßverläufen aufweist, dadurch gekennzeichnet, daß ein Stoßwellengenerator (1) mit einem Hauptkondensator (12) versehen ist, dessen einer Anschluß direkt und dessen anderer Anschluß über eine Spule (3) und einen Hauptschalter (10) mit dem Kabel (11) verbunden ist, daß ein zweiter Impulskondensator (7) über einen Kontakt gemeinsam mit dem Hauptkondensator (12) direkt an das Kabel (11) angeschlossen ist und über einen anderen Kontakt über einen Kurzschlußschalter (8) und den Hauptschalter (10) an das Kabel (11) angeschlossen ist, daß eine Funkenstrecke (4) mit einer Triggerelektrode (14) und einer Hauptelektrode (15,16) versehen ist, wobei die Triggerelektrode (14) über eine Zündspule (2), die magnetisch mit der Spule (3) gekoppelt ist, an eine Verbindungsstelle des Hauptkondensators (12), der Spule (3) und eines Ladewiderstandes (5) des Impulskondensators (7) angeschlossen ist und der Kurzschlußschalter (8) als Kurzschlußschalter für die Hauptelektroden (15,16) ausgebildet ist und daß über eine Auskopplung (6) ein Digitalspeicher (9) an eine Zuleitung des Impulskondensators (7) angeschlossen ist, die den Impulskondensator (7) mit dem Kabel (11) verbindet.

4. Vorrichtung nach der Anspruch 3, dadurch gekennzeichnet, daß der Impulskondensator (7) eine geringe Eigeninduktivität aufweist.

5. Vorrichtung nach Anspruch 3 oder 4, dadurch gekennzeichnet, daß die Zündspule (2) und die Spule (3) als ein einheitliches Bauelement ausgebildet sind.

6. Vorrichtung nach einem der Ansprüche 3 bis 5, dadurch gekennzeichnet, daß der Ladewiderstand (5) eine Dimensionierung derart aufweist, daß bei einem Ladevorgang des Impulskondensators (7) die Spannung am Impulskondensator (7) der Spannung am Hauptkondensator (12) folgt und daß eine ausreichende elektrische Entkopplung des Impulskondensators (7) und des Hauptkondensators (12) beim schnellen Entladevorgang realisiert ist.
